# EUROPEAN PATENT SPECIFICATION

(11) **EP 0 926 715 B1**
(45) Date of publication and mention of the grant of the patent: **10.06.2009**
(21) Application number: 98310556.0
(22) Date of filing: 22.12.1998
(51) Int. Cl.: H01L 21/3105

(54) **Chemical mechanical polishing for isolation dielectric planarization**
Chemisch-mechanisches Polieren für die Planarisierung isolierender Dielektrika
Polissage mécano-chimique pour la planarisation de couches diélectriques isolantes

(30) Priority: 23.12.1997 US 68661 P; 21.05.1998 US 86215 P
(43) Date of publication of application: 30.06.1999
(73) Proprietor: Texas Instruments Incorporated, Dallas, Texas 75265 (US)
(72) Inventor: Olsen, Leif C., Plano, Texas 75025 (US); Swanson, Leland S., Mc Kinney, Texas 75070 (US); Edwards, Henry L., Garland, Texas 75044 (US)
(74) Representative: Harris, Ian Richard

(56) References cited:
- EP-A- 0 545 263
- US-A- 5 362 669

## Description

The present invention relates to integrated circuit structures and fabrication methods, and particularly to chemical mechanical polish (CMP) stops used for isolation dielectric planarization.

Chemical mechanical polishing (CMP) is a planarization technique which has become increasingly important in integrated circuit processing in the 1990s. CMP, unlike most other planarization techniques, provides global planarization. This global planarization avoids problems of step coverage, and hence helps achieve the numerous multiple layers of metallization which are now desired. Global planarization also improves lithographic resolution, by removing constraints on the depth of field.

In a CMP process, a wafer is polished in a slurry of a very fine abrasive (typically alumina, Al₂O₃). The slurry has a chemical composition which accelerates removal of the top surface. For example, for removal of tungsten an acidic and oxidizing slurry is used; this helps to convert the surface of the tungsten into a tungsten oxide, which is easily removed by the mechanical polishing operation. For removal of dielectrics, a basic chemistry is more typically used.

General discussion of CMP techniques can be found in Ali et al., "Chemical-mechanical polishing of interlayer dielectric: a review," which appeared at page 63 of the October 1994 issue of SOLID STATE TECHNOLOGY, and references cited therein. (Note, however, that this article is particularly focused on dielectric removal.) Additional discussion can be found in DeJule, "Advances in CMP," SEMICONDUCTOR INTERNATIONAL, November 1996, at pages 88 and following, and references cited therein; and in Kim et al., "Optimized Process Developed for Tungsten CMP," SEMICONDUCTOR INTERNATIONAL, November 1996, at pages 119 and following. All of these materials are hereby incorporated by reference.

To provide the degree of uniformity which is desirable in planarizing integrated circuit processes, CMP stop layers are commonly used with CMP processes. One such CMP stop which is frequently desired is for oxide polishing. This is commonly done by including islands of silicon nitride, and using a slurry which achieves some selectivity to the nitride. However, the selectivities which are achieved with standard slurries are small, only of the order of 4 to 1 or so.

Current state of the art uses silicon nitride as both a silicon etch hardmask, and as a CMP stop layer for chemical-mechanical polishing (CMP). Since the removal selectivity of silicon dioxide to silicon nitride is only 4:1 or 5:1 using industry-accepted slurries, the silicon nitride layer is not an effective CMP polish stop layer. Nonuniformity due to polish and pattern effects can cause the dielectric SiO₂ and silicon nitride over small isolated active device features to be polished much more quickly than other features, thus causing damage to these small active regions.

Some attempts have been made to achieve higher oxide: nitride selectivities by using other chemistries. One example of this is a chemistry in which the standard SS25 silica polishing slurry is modified by the addition of tetramethyl ammonium fluoride. However, the use of silicon nitride requires either a patterned etchback approach (which requires additional lithography steps) or the use of CMP slurries which include chemicals to passivate the silicon nitride surface and provide high selectivity in CMP removal of SiO₂, The patterned etchback approach is more expensive than other approaches. High selective slurries are not in mass production and have not yet gained wide industry acceptance, partly because they are difficult to clean from the wafer surface after CMP processing, and they have limited shelf and pot lives.

US-A-5 362 669 discloses a method using a sic layer as both a silicon etch mask, and CMP stop layer.

The invention is as defined in the claims.

According to described examples there is provided a CMP process with silicon carbide polish stop layers. Thus, silicon carbide layers are used in a CMP process, or alternatively, a silicon carbonitride or silicon carboxide. It has been found that standard polishing chemistries will very easily give an extremely high selectivity (50 to 1 or better) between silicon dioxide and silicon carbide. This means that nonuniformities in oxide thickness or in polish rate will be smoothed out when the faster etching areas can be covered by polish stop layers. It has also been found that silicon nitride can also be polished selectively with respect to silicon carbide, with a polish rate ratio which is greater than 12 to 1.

One particularly important embodiment of the disclosed process is to provide a polish stop layer for planarization of the isolation dielectric, such as shallow trench isolation, prior to formation of transistors. A layer of silicon carbide is deposited and patterned to serve as a hardmask for the trench etch. After filling of the trenches with dielectric, the silicon carbide serves as a polish stop, allowing a smoother planarization than is otherwise possible. A dummy moat is used in this process.

According to described examples there is provided a fabrication method for an integrated circuit structure, comprising the steps of: forming an oxide structure which includes, distributed there-through, a first layer comprising silicon and carbon; and polishing said oxide structure, using a slurry composition which has a selectivity to said first layer of greater than 10 to 1, so that said polishing step smoothly removes said oxide on a first side of said first layer and stops on exposed areas of said first layer; whereby said exposed areas of said first layer define a uniform surface level for said oxide structure. The first layer may contain at least one percent as much carbon as silicon, or at least 0.01 percent or 0.0001 percent as much carbon as silicon.

According to described examples there is provided a fabrication method for an integrated circuit structure, comprising the steps of: (a) providing a substrate which includes a body of semiconductor material; (b) depositing a first layer comprising silicon and carbon over said semiconductor material; (c) forming isolation structures which extend through said first layer into said semiconductor material; (d) filling said isolation structures with a dielectric which also extends over at least a portion of said first layer; (e) performing polishing to planarize said integrated circuit structure; wherein said first layer acts as a polish stop for said polishing step.

Advantages achievable with the disclosed methods and structures include:
- additional (addition to moat pattern) patterned etch steps are not needed;
- slurries with wide industry acceptance can be used;
- less expensive than currently accepted approaches that use silicon nitride and reverse moat pattern and etchback;
- requires fewer process steps than patterned etchback approaches;
- compatible with existing CMP slurries;
- compatible with pads which have wide industry acceptance.

For a better understanding of the invention and to show how the same may be carried into effect reference is now made by way of example to the accompanying drawings in which:
Figure 1 is a flowchart of a process using silicon carbide; and
Figures 2A-2C show a cross-section of a wafer during various steps in the process of Figure 1.

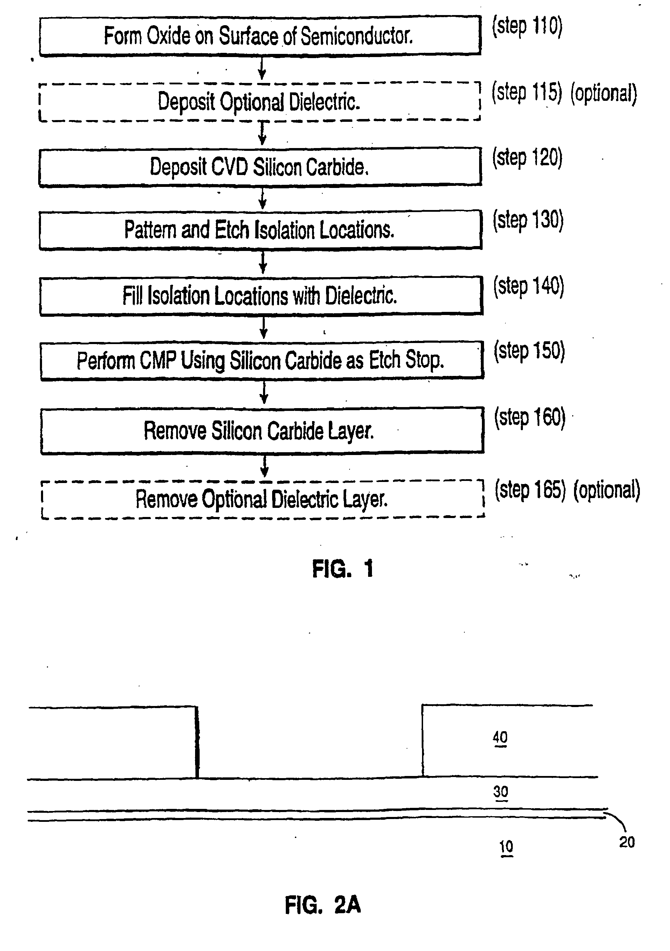

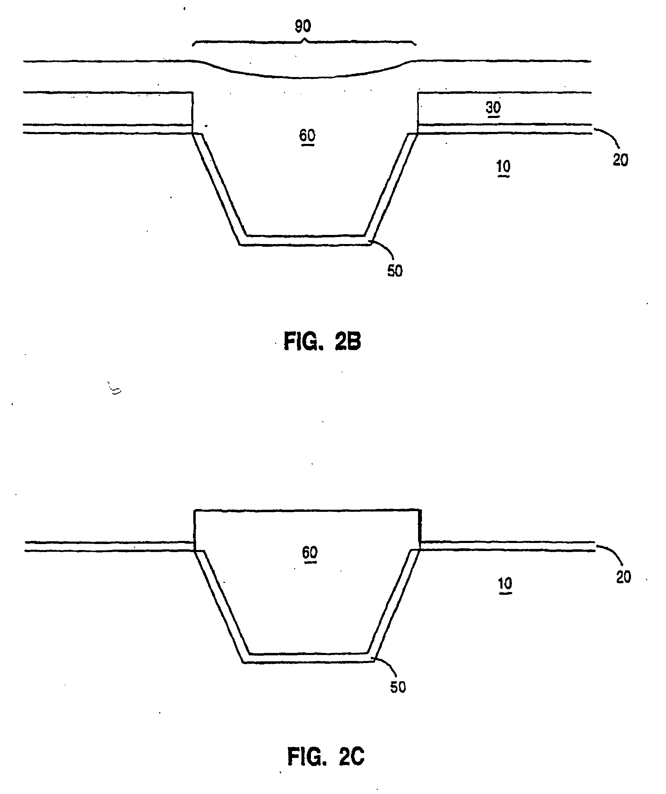

Figure 1 is a flowchart of an embodiment of a process, which will now be discussed also with regard to Figures 2A-2C. The process begins with a bare wafer on which an oxide is grown (step 110) to a thickness of approximately 7.5-30 nm. Optionally, a thin dielectric underlayer (not shown) can be deposited at this time. In the presently preferred embodiment, this can be silicon nitride having a thickness between 20 and 300 nm. This is followed by deposition of approximately 20-250 nm of silicon carbide (step 120). In the present embodiment, the silicon carbide is deposited in a single plasma-enhanced chemical vapour deposition (PECVD) process, with the following recipe:

| | |
|---|---|
| Source gas: | silane methane, trimethylsilane, or other organosilicon gas; |
| Carrier gas: | Ar or He; |
| Pressure: | about 2-8 Torr; |
| Gas flow | 500-5000 sccm; |
| RF power density: | about 2 W/cm2 (13.56 MHz); |
| Substrate temperature: | 200-500 (preferably 350) degrees C. |

Following the SiC deposition, photoresist is deposited and patterned to expose areas where isolation structures are desired, giving the structure shown in Figure 2A. The silicon carbide, optional nitride, oxide and silicon are etched (step 130) to form trenches 90. A thin layer of oxide will typically be grown on the walls of the trench, then the trench is overfilled (step 140) with a dielectric, typically a silicon dioxide, giving the structure in Figure 2B. Following the SiC deposition, photoresist is deposited and patterned to expose areas where isolation structures are desired, giving the structure shown in Figure 2A. The silicon carbide, optional nitride, oxide and silicon are etched (step 130) to form trenches 90. A thin layer of oxide will typically be grown on the walls of the trench, then the trench is overfilled (step 140) with a dielectric, typically a silicon dioxide, giving the structure in Figure 2B.

Chemical-mechanical polishing (CMP) is then performed (step 150) until all the remaining silicon carbide is exposed. Parameters in the polish step are as follows, with ranges given first and presently preferred values in parenthesis:

### Polish Parameters:

| | |
|---|---|
| Downforce | 2-10 (6.5) psi |
| Back Pressure | 0.5-5 (1.5) psi |
| Table Speed | 15-100 (32) rpm |
| Carrier Speed | 15-100 (28) rpm |
| Conditioning | 1-7 (3) 1ibs/30 rpm/in situ/1.5 seconds per segment |
| Slurry Flow | 50-700 (200) ml/min |

Example of Consumables in Polish (many others can be used):

| | |
|---|---|
| Pad | ICI400, K-Groove - Vendor = Rodel |
| Slurry | SS25 diluted 3:2 with DI H2O; Vendor = Cabot |
| Backing Film | DF245, Vendor = Rodel |

Following the CMP step, the silicon carbide and other dielectrics will be removed, resulting in a planar active area. In order for the CMP step to give the desired results, it is necessary to design a dummy active area pattern, i.e. area that is patterned as an active area, but is not electrically active. This dummy area serves to eliminate large trench area that would be dished during CMP planarization and could thereby cause damage to active areas at the edges of wide trenches. Instead, the dummy areas provide support for the CMP pad, allowing only minimum bending of the pad surface.

### First Etch Embodiment for SiC:

In a first embodiment, the process used to etch the silicon carbide is a Cl₂/O₂ etch, at about 600-900 degrees C, with a Cl₂ flow of 1-20 litres/minute and O₂ flow of 1-20 litres/minute, at atmospheric pressure. The Cl₂/O₂ will selectively etch the SiC from the SiO₂ surface.

### Second Etch Embodiment for SiC:

In an alternative embodiment, the process used to etch the silicon carbide is a Cl₂ etch, at about 300 mTorr, with gas flow of 10-300 sccm, Ar flow of 0-100 sccm, O2 flow of 0-50 sccm, RF power density of about 0.5-4 *W*/*cm²* (13.56 MHz), and magnetic field of 0-30 G. Removal rates for SiC relative to SiO₂ of 10:1 have been achieved.

### Third Etch Embodiment for SiC:

In an alternative embodiment, the etch uses a chemistry of CF₄/O₂/H₂/Ar, with an O₂ fraction of 0-90 percent, H₂ flow of 0-20 sccm, (fluorinated-O₂ gas flow of 10-50 sccm), Ar flow of 10-100 sccm, chamber pressure of about 10-50 mTorr, RF Power density of about 0.5-4 W/cm² (13.56 MHz), and magnetic field of 0-30 G.

### Fourth Etch Embodiment for SiC:

In a further alternative embodiment, the etch uses a SF₆/O₂H₂/Ar chemistry, with an O₂ fraction of 0-90%, H₂ flowrate of 0-20 sccm, (fluorinated-O₂ gas flow 10-50 sccm), Ar flow of 10-100 sccm, a chamber pressure of about 10-50 mTorr, RF Power density of about 0.5-4 W/cm² (13.56 MHz), and magnetic field of 0-30 G.

### Fifth Etch Embodiment for SiC:

In a further alternative embodiment, the etch uses a chemistry of NF₃/CHF₃/CF₄/Ar/O₂/H₂, with an O₂ fraction of 0-50 percent, H₂ flow of 0-100 sccm, (fluorinated-Ar gas flow of 50-200 sccm), Ar flow of 10-100, chamber pressure of about 10-50 mTorr, RF Power density of approximately 0.5-4 W/cm² (13.56 MHz), and magnetic field of 0-30 G.

### Experimental Data

The following data was taken by measurements on sheetfilm deposited on pilot wafers.

| Source | Deposition Temperature | CMP Selectivity to Oxide |
|---|---|---|
| TMS | 250 C | 10.6:1 |
| TMS | 350C | 43:1 |
| TMS | 500 C | 44:1 |
| Silane/Methane | 350C | 50:1 |

| | | |
|---|---|---|
| TMS = Trimethylsilane | | |

Wafers deposited with the silane/methane chemistry appeared overall to have better CMP selectivity to SiO₂ and fewer defects and film thickness uniformity. There exists some variation in CMP selectivity of SiO₂:SiC dependent on the location on the wafer. The CMP removal rate selectivity near the wafer centre of SiO,:SiC was actually 70:1 whereas the selectivity near the edge of the wafer was 37:1.

The high levels of CMP removal rate selectivity of oxide to silicon carbide indicate that silicon carbide is a very good stopping layer for CMP oxide planarization processes. Compared to the current state of the art using silicon nitride as a stop layer that has removal rate selectivity (oxide:nitride) of 4:1 except using advanced slurries where removal rate selectivity ranges from 12:1 to reported 20:1, silicon carbide will be much better than silicon nitride since less SiC material will be removed.

The CMP process is standard for undoped oxide removal at transistor isolation, and interlevel dielectric planarization.

### Alternative Embodiments

Alloys of silicon carbide with other materials are also possible CMP stop layers. The chief difficulty in selecting these alloys is to maintain a balance between the hardness of the material, important in CMP, and the selectivity of the stop layer etch to SiO₂.

In one alternative embodiment, silicon carbide is alloyed with nitrogen to form a silicon carbonitride SiₓC_{y}N_{z}. Given the nitride bonds in this material, it may be possible to remove this layer with a wet etch, such as the hot phosphoric acid bath used to remove silicon nitride.

In another alternative embodiment, silicon carbide is alloyed with oxygen to form a silicon carboxide SiₓC_{y}O_{z} layer. This embodiment is generally less preferred, as selectivity to oxide is not as easy to obtain with this material, due to its own oxide bonds. However, there is some evidence that the silicon carbide deposited in the primary embodiment may have more oxygen than would be expected.

In another alternative embodiment, silicon carbide is alloyed with both nitrogen and oxygen, forming a silicon carboxynitride SiₓCₓNyO_{z}.

## Claims

1. An integrated circuit structure, fabrication method, comprising:
growing an oxide on a silicon wafer;
depositing a silicon nitride layer on said oxide
depositing a first layer of silicon carbide and optionally alloying said silicon carbide with nitrogen to form a silicon carbonitride or alloying said silicon carbide with oxygen to form a silicon carboxide or alloying said silicon carbide with both nitrogen and oxygen to form a silicon carboxynitride on said nitride;
forming isolation trenches extending through said layers into said silicon wafer;
overfilling said trenches with silicon dioxide;
chemical-mechanical polishing said silicon dioxide to planarize said integrated circuit structure, wherein said polishing stops on said first layer, which acts as a polish stop layer, and
removing said first layer and said silicon nitride.

2. The method of claim 1, further comprising:
prior to said overfilling, growing a thin layer of oxide on the walls of said trenches.

## Patentansprüche

1. Verfahren zur Herstellung einer integrierten Schaltungsstruktur, das Folgendes umfasst:
Aufwachsen eines Oxids auf einem Siliciumwafer;
Abscheiden einer Siliziumnitridschicht auf dem Oxid;
Abscheiden einer ersten Schicht Siliciumcarbid und wahlweise Legieren des Siliciumcarbids mit Stickstoff unter Bildung eines Siliciumcarbonitrids oder Legieren des Siliciumcarbids mit Sauerstoff unter Bildung eines Siliciumcarboxids oder Legieren des Siliciumcarbids sowohl mit Stickstoff als auch mit Sauerstoff unter Bildung eines Siliciumcarboxynitrids auf dem Nitrid;
Bilden von Isolationsgräben, die sich durch die Schichten in den Siliciumwafer erstrecken;
Überfüllen der Gräben mit Siliciumdioxid;
chemisch-mechanisches Polieren des Siliciumdioxids zur Planarisierung der integrierten Schaltungsstruktur, wobei das Polieren an der ersten Schicht endet, die als Polierstoppschicht wirkt; und
Entfernen der ersten Schicht und des Siliziumnitrids.

2. Verfahren nach Anspruch 1, das ferner Folgendes umfasst:
Aufwachsen einer dünnen Oxidschicht an den Wänden der Gräben vor dem Überfüllen.

## Revendications

1. Procédé de fabrication d'une structure de circuit intégré, comprenant les étapes consistant à :
faire croître un oxyde sur une plaquette de silicium ;
déposer une couche de nitrure de silicium sur ledit oxyde ;
déposer une première couche de carbure de silicium et éventuellement allier ledit carbure de silicium avec de l'azote de manière à former un carbonitrure de silicium, ou allier ledit carbure de silicium avec de l'oxygène de manière à former un carboxyde de silicium, ou allier ledit carbure de silicium avec à la fois de l'azote et de l'oxygène de manière à former un corboxynitrure de silicium sur ledit nitrure ;
former des tranchées d'isolation qui s'étendent à travers lesdites couches dans ladite plaquette de silicium ;
remplir à l'excès lesdites tranchées avec du dioxyde de silicium ;
polir de manière chimique et mécanique ledit dioxyde de silicium de manière à planariser ladite structure de circuit intégré, dans lequel ledit polissage cesse sur ladite première couche, qui agit en tant que couche d'arrêt de polissage ; et
éliminer ladite première couche et ledit nitrure de silicium.

2. Procédé selon la revendication 1, comprenant en outre l'étape consistant :
avant l'étape consistant à remplir complètement, à faire croître une couche mince d'oxyde sur les parois desdites tranchées.
